# EUROPÄISCHE PATENTANMELDUNG

(11) **EP 1 333 472 A2**
(43) Veröffentlichungstag der Anmeldung: **06.08.2003**
(21) Anmeldenummer: 03000289.3
(22) Anmeldetag: 09.01.2003
(51) Int. Cl.: H01L 21/20

(54) **Verfahren zum Herstellen eines Hohlraums in einem monokristallinen Siliziumsubstrat und Halbleiterbaustein mit einem Hohlraum in einem monokristallinen Siliziumsubstrat mit einer epitaktischen Deckschicht**

(30) Priorität: 21.01.2002 DE 10202140
(71) Anmelder: Infineon Technologies AG, 81669 München (DE)
(72) Erfinder: Popp, Martin, 01109 Dresden (DE); Temmler, Dietmar, 01109 Dresden (DE); Schupke, Kristin, 01478 Weixdorf (DE); Schilling, Uwe, 01309 Dresden (DE); Pomplun, Kerstin, 01097 Dresden (DE)
(74) Vertreter: Patentanwaltskanzlei WILHELM & BECK

(57) **Zusammenfassung**

Verfahren zum Herstellen eines Hohlraums in einem monokristallinen Siliziumsubstrat und Halbleiterbaustein mit einem Hohlraum in einem monokristallinen Siliziumsubstrat mit einer epitaktischen Deckschicht

Es wird ein Verfahren und ein Halbleiterbaustein mit einem Hohlraum beschrieben, wobei ein Hohlraum in ein monokristallines Siliziumsubstrat eingebracht wird, die Wandung des Hohlraums mit einer Abdeckschicht bedeckt wird und anschliessend mit einem selektiven, epitaktischen Aufwachsverfahren eine Deckschicht auf die Oberfläche des Siliziumsubstrates aufgebracht wird und dabei der Hohlraum abgedeckt wird. Das beschriebene Verfahren ist einfach aufgebaut und kostengünstig durchzuführen. Insbesondere kann das beschriebene Verfahren dazu verwendet werden, um bei der Herstellung eines DRAM-Speichers einen Graben vor Hochtemperaturprozessen abzudecken und nach den Hochtemperaturprozessen wieder zu öffnen und als Grabenkondensator fertig zu stellen.

## Beschreibung

Verfahren zum Herstellen eines Hohlraums in einem monokristallinen Siliziumsubstrat und Halbleiterbaustein mit einem Hohlraum in einem monokristallinen Siliziumsubstrat mit einer epitaktischen Deckschicht

Die Erfindung betrifft ein Verfahren zum Herstellen eines Hohlraums in einem Siliziumsubstrat gemäß dem Oberbegriff des Patentanspruchs 1 und einen Halbleiterbaustein mit einem Hohlraum in einem monokristallinen Siliziumsubstrat, der von einer epitaktischen Schicht bedeckt ist, gemäß dem Oberbegriff des Patentanspruchs 9.

Halbleiterbausteine wie z.B. DRAM-Speicher werden durch eine Vielzahl von technologischen Verfahrensschritten hergestellt. Dabei kann es erforderlich sein, einen Hohlraum in ein Siliziumsubstrat einzubringen und den Hohlraum anschliessend beispielsweise mit einer Schichtfolge aufzufüllen, um einen Grabenkondensator herzustellen. Der Grabenkondensator wird in weiteren Herstellungsverfahren anschließend mit einem Auswahltransistor leitend verbunden, der ebenfalls auf dem Siliziumsubstrat hergestellt wird. Auf diese Weise wird eine Speicherzelle für einen DRAM-Speicher hergestellt.

Es ist jedoch auch in anderen Anwendungsbereichen, wie z.B. der Mikrosystemtechnik, erforderlich, Hohlräume in ein Siliziumsubstrat einzubringen und den Hohlraum zu verschließen. Beispielsweise werden Drucksensoren in Form von Hohlräumen ausgebildet, die mit einer Druckmembran abgedeckt sind. Die abgedeckten Hohlräume stellen entweder nur ein Zwischenstadium oder ein Endstadium bei der Herstellung eines Halbleiterbausteins dar.

Die Aufgabe der Erfindung besteht darin, ein einfaches Verfahren zum Herstellen eines Hohlraums in einem Siliziumsubstrat bereit zu stellen. Weiterhin besteht die Aufgabe der Erfindung darin, einen Halbleiterbaustein mit einem Hohlraum bereit zustellen, wobei der Hohlraum mit einer Deckschicht abgedeckt ist, die auf einfache Art und Weise herstellbar ist.

Die Aufgaben der Erfindung werden durch die Merkmale der Patentansprüche 1 und 9 gelöst.

Ein Vorteil des erfindungsgemäßen Verfahrens gemäß dem Patentanspruch 1 besteht darin, dass ein in ein Siliziumsubstrat eingebrachter Hohlraum über ein einfaches Verfahren mit einer epitaktischen Deckschicht abgedeckt wird. Dazu wird auf die Wandung des Hohlraums eine Abdeckschicht aufgebracht und anschließend über ein selektives, epitaktisches Abscheideverfahren eine Deckschicht auf das Substrat aufgebracht. Das Verfahren der Herstellung der Abdeckschicht ist in der Weise ausgewählt, dass das abzuscheidende Material nicht auf der Abdeckschicht aufwächst. Somit wird die Öffnung des Hohlraums, die an der Oberfläche des Substrates angeordnet ist, durch das selektive epitaktische Abscheideverfahren vollständig bedeckt. Somit wird in einem einfachen Herstellungsverfahren ein Hohlraum mit einer epitaktischen Deckschicht in einem monokristallinen Siliziumsubstrat hergestellt. Insbesondere bleibt dabei die monokristalline Struktur auch in der Deckschicht erhalten, so dass auf der Deckschicht Transistoren hergestellt werden können.

Weitere vorteilhafte Ausführungsformen der Erfindung sind in den abhängigen Ansprüchen angegeben.

In einer bevorzugten Ausführungsform wird als Abdeckschicht eine Siliziumdioxidschicht aufgebracht. Die Verwendung einer Siliziumdioxidschicht bietet eine einfache und zuverlässige Technologie zum Aufbringen einer Abdeckschicht, auf der eine Siliziumschicht, die nach einem selektiven, epitaktischen Abscheideverfahren abgeschieden wird, nicht aufwächst.

In einer weiteren bevorzugten Ausführungsform der Erfindung wird der Hohlraum nach dem Aufbringen der Abdeckschicht mit einer Stopschicht ausgefüllt. Die Stopschicht ist in der Weise ausgebildet, dass die Stopschicht nicht von einem selektiven Nassätzverfahren entfernt wird. Auf diese Weise kann ein selektives Nassätzverfahren eingesetzt werden, um die Abdeckschicht im oberen Randbereich der Wandung zu entfernen. Somit ist eine weitere bevorzugte Ausführungsform für ein einfaches Herstellungsverfahren gegeben.

Vorzugsweise wird als Stopschicht ein lichtempfindlicher Lack, ein Photoresist verwendet, der kostengünstig ist, einfach in den Hohlraum eingebracht werden kann, und vorzugsweise mittels eines Plasmaätzverfahrens wieder aus dem Graben entfernt werden kann.

In einer bevorzugten Ausführungsform wird das erfindungsgemäße Verfahren dazu verwendet, um einen Graben für einen Grabenkondensator in ein Siliziumsubstrat einzubringen, wobei jedoch der Graben erst nach Durchführung von Hochtemperaturschritten mit einer dielektrischen Schicht und einer elektrisch leitenden Schicht mindestens teilweise aufgefüllt wird und dadurch ein Grabenkondensator hergestellt wird. Der Graben selbst wird vor der Durchführung der Hochtemperaturschritte in Form eines Hohlraums mit epitaktischer Deckschicht in das Siliziumsubstrat eingebracht. Somit können für die Herstellung des Grabenkondensators Materialien verwendet werden, die Hochtemperaturprozesse, wie sie bei der Herstellung eines Speicherbausteins üblich sind, nicht unbeschadet überstehen, aber bevorzugte Eigenschaften für die Funktionsweise des Grabenkondensators aufweisen.

Vorzugsweise können dielektrische Materialien verwendet werden, die eine große Dielektrizitätskonstante aufweisen, aber bei Temperaturen von über 800° C nicht stabil sind. Weiterhin können als elektrische Elektroden oder Leitungen zur Kontaktierung des Grabenkondensators metallische Schichten verwendet werden. Das Einbringen der metallischen Schichten nach der Durchführung der Hochtemperaturprozesse bietet den Vorteil, dass die metallischen Schichten nicht den hohen Temperaturen ausgesetzt werden und somit die elektrische Funktionsweise des Grabenkondensators oder des Siliziumsubstrats nicht beeinträchtigen.

Versuche haben gezeigt, dass bei der Ausbildung der Deckschicht nach dem beschriebenen Verfahren die Deckschicht eine vorgegebene Tiefe in den Hohlraum hineinwächst. Dadurch wird die Stabilität der Deckschicht erhöht. Somit ist die Deckschicht weniger empfindlich gegenüber einer mechanischen Beschädigung.

Die Erfindung wird im folgenden anhand der Figuren näher erläutert. Es zeigen
Fig. 1 ein erstes Verfahren zur Herstellung eines Hohlraums in einem Siliziumsubstrat mit einer epitaktischen Deckschicht,
Fig. 2 ein zweites Verfahren zur Herstellung eines Hohlraums in einem Siliziumsubstrat mit einer epitaktischen Deckschicht und
Fig. 3 ein Verfahren zur Herstellung einer Speicherzelle eines DRAM-Speichers.

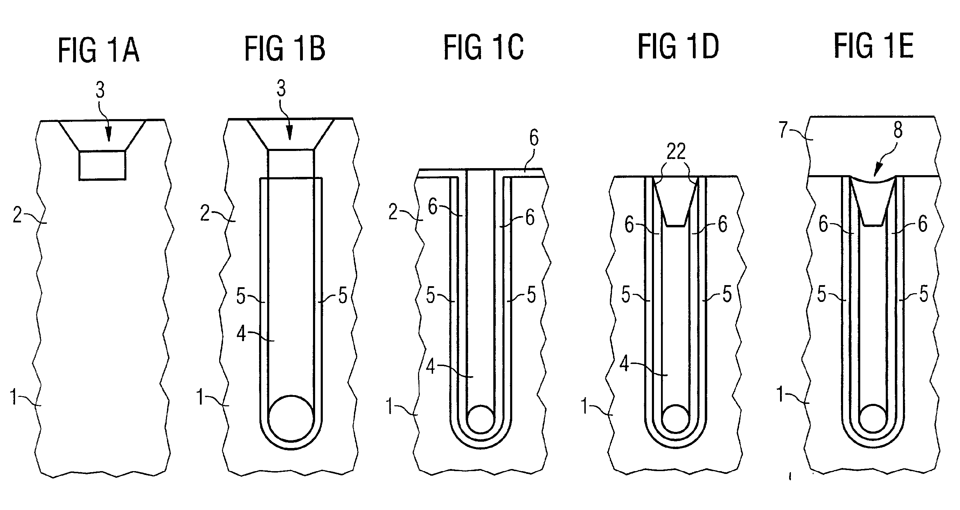

Fig. 1 a zeigt ein Siliziumsubstrat 1, das mit einer Hartmaske 2 bedeckt ist. In der Hartmaske 2 ist ein Ätzkanal 3 ausgebildet. Das Siliziumsubstrat 1 , die Hartmaske 2 und der Ätzkanal 3 sind im Querschnitt dargestellt. In einem folgenden Verfahrensschritt wird über die Hartmaske 2 ein Hohlraum 4 in das Siliziumsubstrat eingebracht. Der Hohlraum 4 kann jede beliebige Form aufweisen und ist in der Ausführungsform der Fig. 1 b in Form eines Grabens ausgebildet. Zum Einbringen des Hohlraums 4 kann beispielsweise ein anisotropes Ätzverfahren eingesetzt werden.

In einem weiteren Verfahrensschritt wird in einer bevorzugten Ausführungsform der Erfindung eine Dotierschicht 5 in das Siliziumsubstrat 1 angrenzend an den Hohlraum 4 eingebracht. Die Dotierschicht 5 wird beispielsweise dadurch erzeugt, dass der Hohlraum 4 mit einer mit Arsen dotierten Glasschicht gefüllt wird und in einem anschließenden Diffusionsverfahren die an den Hohlraum 4 angrenzenden Bereiche des Siliziumsubstrats 1 mit Arsen dotiert werden. Dieser Verfahrensstand ist in Fig. 1 b dargestellt.

Anschließend wird die Hartmaske 2 entfernt und über ein Oxidationsverfahren eine erste Abdeckschicht 6 vorzugsweise in Form einer Oxidationsschicht, auf die Wandung des Hohlraums 4 und auf die Oberfläche des Substrates 1 aufgebracht. Die erste Abdeckschicht 6 kann auch aus einem anderen Material hergestellt werden, wobei die wesentliche Aufgabe der ersten Abdeckschicht 6 darin besteht, dass auf der ersten Abdeckschicht 6 bei einem folgenden selektiven, epitaktischen Abscheideverfahren keine Schicht aufwächst. Dieser Verfahrensstand ist in Fig. 1 c dargestellt.

Anschließend wird die erste Abdeckschicht 6 von der Oberfläche des Siliziumsubstrates 1 entfernt. In einem weiteren Verfahrensschritt wird daraufhin die erste Abdeckschicht 6 im Randbereich des Hohlraums 4 abgeätzt. Die Abätzung erfolgt in der Weise, dass die erste Abdeckschicht 6 ausgehend von der Oberfläche des Siliziumsubstrates 1 in Richtung in den Hohlraum 4 an Dicke zunimmt. Dadurch weist die Oberfläche der Abdeckschicht 6 im Randbereich einen vorgegebenen Neigungswinkel 22 auf. Dieser Verfahrenszustand ist in Fig. 1 d dargestellt. Die Verwendung einer im Randbereich abgeschrägten Abdeckschicht 6 bietet bessere Eigenschaften beim Aufwachsen der epitaktischen Deckschicht 7.

In einem folgenden Verfahrensschritt wird eine epitaktische Siliziumschicht auf das Siliziumsubstrat 1 mit einem selektiven, epitaktischen Abscheideverfahren aufgebracht. Auf diese Weise wird eine Deckschicht 7 auf der Oberfläche des Siliziumsubstrates 1 erzeugt, das auch den Öffnungsbereich des Hohlraums 4 abdeckt. Aufgrund des selektiven epitaktischen Abscheideverfahrens wird die epitaktische Siliziumschicht nur auf einer Siliziumoberfläche abgeschieden, sodass auf der Abdeckschicht 6 keine epitaktische Siliziumschicht aufwächst.

Zur Abscheidung der epitaktischen Deckschicht 7 wird beispielsweise ein CVD-Verfahren verwendet, in dem bei einer Temperatur von 900° C aus einer Mischung aus Dichlorsilan und HCL die epitaktische Siliziumschicht abgeschieden wird. Vorzugsweise wird Dichlorsilan mit 180 sccm und HCL mit 60 sccm als Mischung verwendet.

Bei dem selektiven epitaktischen Abscheideverfahren wird die Deckschicht 7 mit einer Wölbung 21 in den Hohlraum 4 abgeschieden. Die Ausbildung der Wölbung 21 bietet den Vorteil, dass die Deckschicht 7 eine erhöhte mechanische Stabilität aufweist. Dadurch ist der Hohlraum 4 zuverlässiger abgedeckt.

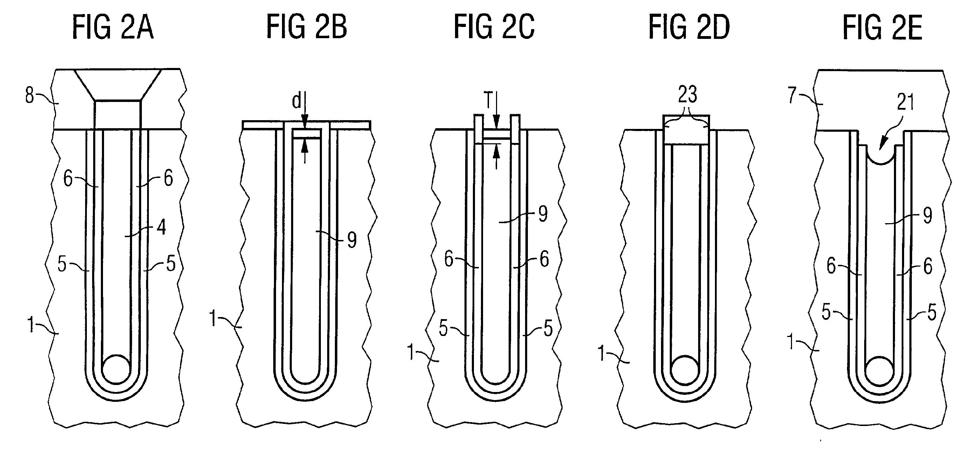

Fig. 2 zeigt ein zweites Verfahren zur Herstellung eines Hohlraums 4 mit einer Deckschicht 7. In Fig. 2 a ist bereits der Verfahrensstand entsprechend der Fig. 1 c dargestellt. Die vorhergehenden Schritte wurden entsprechend den Verfahrensschritten der Fig. 1 a, 1 b und 1 c ausgeführt. In das Siliziumsubstrat 1 ist bereits ein Hohlraum 4 mit einer Abdeckschicht 6 und vorzugsweise einer Dotierschicht 5 eingebracht. Die Abdeckschicht 6 ist auch auf der Oberfläche des Siliziumsubstrates 1 angeordnet.

Das Stopmaterial ist insbesondere gegenüber gewissen nasschemischen Ätzverfahren stabil. Dieser Verfahrenszustand ist in Fig. 2 b dargestellt.

Anschließend wird über ein Ätzverfahren die Abdeckschicht 6 im Randbereich des Hohlraums 4 eine vorgegebene Tiefe T, vorzugsweise mit einem Nassätzverfahren, ausgeätzt und dadurch das Siliziumsubstrat 1 im Randbereich freigelegt. Die Abdeckschicht 6 wird vorzugsweise durch nasschemische Ätzverfahren entfernt, gegen die das Stopmaterial 9 resistent ist. Anstelle eines Belichtungslackes kann auch jede andere Art von Stopschicht verwendet werden, die eine Selektivität gegenüber nasschemischen Ätzverfahren aufweist.

Anschließend wird das Stopmaterial 9 aus dem Hohlraum 4 entfernt. Bei der Ausbildung des Stopmaterials 9 als Belichtungslack wird der Belichtungslack durch ein plasmachemisches Ätzverfahren abgeätzt. Dieser Verfahrenszustand ist in Fig. 2 d dargestellt. In einem folgenden Aufwachsprozessschritt wird die Deckschicht 7 mit dem selektiven epitaktischen Abscheideverfahren aufgebracht. Dabei wird eine epitaktische Siliziumschicht 7 auf der Oberfläche des Siliziumsubstrates 1 aufgewachsen. Da ein Randbereich 23 des Hohlraums 4 eine Siliziumfläche aufweist, wächst auch in diesem Bereich die epitaktische Deckschicht 7 an. Die tiefer angeordnete Abdeckschicht 6 verhindert ein Anwachsen der Siliziumschicht, sodass der Hohlraum 4 im wesentlichen von Siliziummaterial frei bleibt. Jedoch wächst aufgrund der gewählten Geometrie die Abdeckschicht 7 in einem Wölbungsbereich 21 in Richtung des Hohlraums 4. Auf diese Weise wird eine Deckschicht 7 ausgebildet, die eine verbesserte mechanische Stabilität über dem Hohlraum 4 aufweist und die Ausbildung von Kristalldefekten verhindert. Somit erweist sich das verwendete Verfahren als vorteilhaft für die mechanische Stabilität und die elektrischen Eigenschaften der Deckschicht 7.

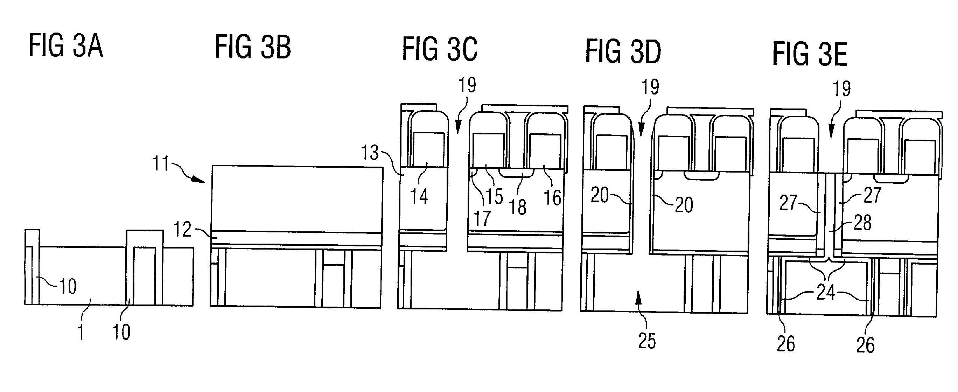

Fig. 3 zeigt Ausschnitte eines Verfahrens zur Herstellung einer Speicherzelle eines DRAM-Speichers. In Fig. 3 a ist ein Siliziumsubstrat 1 dargestellt, das Dotierschichten 10 aufweist. Der Graben 25 wird seitlich von den Dotierschichten 10 begrenzt, ein Graben 25 aus dem Siliziumsubstrat herausgeätzt. Anschließend wird die über die Oberfläche des Substrates 1 hinausragende Dotierschicht 10 entfernt und der Graben 25 mit einer epitaktischen zweiten Siliziumschicht 11 abgedeckt. Der Graben 25 mit der zweiten Siliziumschicht 11 stellt einen Hohlraum dar, der mit einer epitaktischen Schicht gemäß der Verfahren der Fig. 1 und 2 bedeckt wurde. Angrenzend an das Siliziumsubstrat 1 wird in die zweite Siliziumschicht 11 mit einem Dotierverfahren eine zweite Dotierschicht 12 eingebracht. Dieser Verfahrenszustand ist in Fig. 3 b dargestellt. In weiteren Verfahrensschritten wird eine STI-Isolationsschicht 13, eine erste, zweite, dritte Wortleitung 14, 15, 16 und ein erstes und zweites Dotiergebiet 17,18 auf die zweite Siliziumschicht 11 auf- bzw. eingebracht. Zudem wurde in die zweite Siliziumschicht 11 ein zweiter Ätzkanal 19 eingeätzt. Dieser Verfahrenszustand ist in Fig. 3 c dargestellt.

In einem weiteren Verfahrensschritt werden die Seitenwände des zweiten Ätzkanals 19 mit einer zweiten Abdeckschicht 20, die vorzugsweise aus Siliziumnitrit gebildet ist, bedeckt. Daraufhin wird ein Graben 25 über ein Ätzverfahren eingebracht. Der Graben 25 wird seitlich von den Dotierschichten 10 begrenzt, ein Graben 25 aus dem Siliziumsubstrat herausgeätzt. Dieser Verfahrenszustand ist in Fig. 3 d dargestellt. Anschließend werden die Wände des Grabens 25 mit einer dielektrischen Schicht 26 und einer elektrisch leitenden Schicht 24 bedeckt. Weiterhin wird in den zweiten Ätzkanal 19 eine Isolationsschicht 27 eingebracht, die in Form eines Isolationskragens ausgebildet ist. Innerhalb des Isolationskragens ist eine zweite leitende Schicht 28 ausgebildet, die die elektrisch leitende Schicht 24 des Grabenkondensators mit dem ersten Dotiergebiet 17 leitend verbindet. Dieser Verfahrenszustand ist in Fig. 3 e dargestellt.

Das erfindungsgemäße Verfahren wird bei der Herstellung einer DRAM-Speicherzelle dazu verwendet, um in das Siliziumsubstrat 1 den Graben 25 einzubringen und anschließend als Deckschicht die zweite Siliziumschicht 11 epitaktisch aufzuwachsen. Die Details sind in den Fig. 3 nicht explizit dargestellt, sondern den Fig. 1 und 2 zu entnehmen. Das beschriebene Verfahren weist den Vorteil auf, dass der Graben 25 während der Hochtemperaturprozesse, bei denen das erste und das zweite Dotiergebiet 17, 18 in die zweite Siliziumschicht 11 eingebracht werden und die Wortleitungen 15, 16 auf die zweite Siliziumschicht 11 aufgebracht werden, ohne Füllung ausgebildet ist. Nach der Durchführung der Hochtemperaturprozesse wird wie in den Fig. 3 c bis 3 e dargestellt ist, der Grabenkondensator mit der dielektrischen Schicht und der elektrisch leitenden Schicht als Elektrode hergestellt. Diese Vorgehensweise bietet den Vorteil, dass als dielektrische Schicht eine temperaturempfindliche Schicht mit bevorzugten Eigenschaften für die Funktionsfähigkeit des Grabenkondensators verwendet werden kann. Zudem kann als elektrisch leitende Schicht eine Metallschicht verwendet werden, die aufgrund der erfindungsgemäßen Vorgehensweise keinen Hochtemperaturprozessen ausgesetzt ist. Damit wird auch die metallische Schicht geschont und zudem erfolgt keine Beeinträchtigung der Funktionsweise der Speicherzelle dadurch, dass die metallische Schicht einer Hochtemperatur ausgesetzt wird und Störeffekte erzeugt.

### Bezugszeichenliste

- 1: Si-Substrat
- 2: Hartmaske
- 3: Ätzkanal
- 4: Hohlraum
- 5: Dotierschicht
- 6: erste Abdeckschicht
- 7: Deckschicht
- 8: Hartmaske
- 9: Stopmaterial
- 10: Dotierschicht
- 11: zweite Si-Schicht
- 12: zweite Dotierschicht
- 13: STI-Isolationsschicht
- 14: erste Wortleitung
- 15: zweite Wortleitung
- 16: dritte Wortleitung
- 17: erstes Dotiergebiet
- 18: zweites Dotiergebiet
- 19: zweiter Ätzkanal
- 20: zweite Abdeckschicht
- 21: Wölbung
- 22: Neigungswinkel
- 23: Randbereich
- 24: elektrisch leitende Schicht
- 25: Graben
- 26: dielektrische Schicht
- 27: dritte Isolationsschicht
- 28: zweite leitende Schicht

## Patentansprüche

1. Verfahren zum Herstellen eines Hohlraums (4,25) in einem monokristallinen Siliziumsubstrat (1), wobei in das Siliziumsubstrat (1) ein Hohlraum (4,25) eingebracht wird,
wobei die Wandung des Hohlraums (4,25) wenigstens im oberen Endbereich mit einer Abdeckschicht (6) bedeckt wird,
**dadurch gekennzeichnet, dass**
auf das Siliziumsubstrat (1) über ein selektiv epitaktisches Verfahren eine Deckschicht (7) aufgebracht wird,
dass die Deckschicht (7) nur auf einer Siliziumoberfläche aufwächst, so dass der Hohlraum mit der Deckschicht (7) bedeckt wird.

2. Verfahren nach Anspruch 1, **dadurch gekennzeichnet, dass** die Abdeckschicht (6) um eine vorgegebene Breite von der Oberfläche des Siliziumsubstrats (1) entfernt wird.

3. Verfahren nach Anspruch 1 oder 2, **dadurch gekennzeichnet, dass** als Abdeckschicht eine Siliziumdioxid-Schicht aufgebracht wird.

4. Verfahren nach einem der Ansprüche 1 bis 3, **dadurch gekennzeichnet, dass** vor dem Entfernen der Abdeckschicht eine Stoppschicht (9) in den Hohlraum (4,25) gefüllt wird, dass anschließend die Abdeckschicht (6) über ein selektives Nassätzverfahren vom oberen Randbereich der Wandung entfernt wird,
dass anschließend die Stoppschicht (9) aus dem Hohlraum herausgeätzt wird.

5. Verfahren nach Anspruch 4, **dadurch gekennzeichnet, dass** als Stoppschicht (9) ein Belichtungslack verwendet wird.

6. Verfahren nach Anspruch 5, **dadurch gekennzeichnet, dass** der Belichtungslack über ein Plasmaätzverfahren nach dem Abätzen der Abdeckschicht (6) vom oberen Randbereich der Wandung wieder entfernt wird.

7. Verfahren nach einem der Ansprüche 1 bis 5, **dadurch gekennzeichnet, dass** der Hohlraum in Form eines Grabens ausgebildet wird, dass angrenzend an den Graben (25) eine Dotierschicht (5) in das Siliziumsubstrat (1) eingebracht wird, dass die Dotierschicht (5) eine Elektrode eines Grabenkondensators darstellt,
dass die Deckschicht (7) wieder entfernt wird,
dass die Wandung des Grabens (25) mit einer dielektrischen Schicht (26)und die dielektrische Schicht (26) mit einer elektrisch leitenden Schicht (24) mindestens teilweise bedeckt wird, und dass die leitende Schicht eine zweite Elektrode des Grabenkondensators bildet.

8. Verfahren nach Anspruch 6, **dadurch gekennzeichnet, dass** aus dem Grabenkondensator eine Speicherzelle gebildet wird, und dass Bauelemente eines Speicherbausteins, insbesondere eines DRAM, in das Siliziumsubstrat (1) ein- bzw.aufgebracht werden.

9. Halbleiterbaustein mit einem monokristallinen Siliziumsubstrat (1) mit einem Hohlraum (4,25), der von einer epitaktischen Schicht (7) bedeckt ist,
**dadurch gekennzeichnet, dass**
die Wandung des Hohlraums (4) wenigstens im oberen Randbereich von einer Abdeckschicht (6) bedeckt ist,
dass die epitaktische Schicht (7) eine vorgegebene Tiefe in den Hohlraum (4,25) hineingewölbt ist.

10. Halbleiterbaustein nach Anspruch 9, **dadurch gekennzeichnet, dass** die epitaktische Schicht (7) aus Silizium gebildet ist und dass die Abdeckschicht (6) aus Siliziumdioxid gebildet ist.

11. Halbleiterbaustein nach einem der Ansprüche 9 oder 10,
**dadurch gekennzeichnet, dass** die epitaktische Schicht (7) an einem vorgegebenen Randbereich an der Wandung des Hohlraums (4,25) angewachsen ist.
